# EUROPÄISCHE PATENTSCHRIFT

(11) **EP 2 537 039 B1**
(45) Veröffentlichungstag und Bekanntmachung des Hinweises auf die Patenterteilung: **01.05.2013**
(21) Anmeldenummer: 12718099.0
(22) Anmeldetag: 29.03.2012
(51) Int. Cl.: G01R 1/067, H01R 31/06

(54) **PRÜFSTIFT ZUM KONTAKTIEREN EINES ELEKTRISCH LEITENDEN BEREICHS EINES KONTAKTPARTNERS**
TESTING PIN FOR MAKING CONTACT WITH AN ELECTRICALLY CONDUCTIVE REGION OF A CONTACT PARTNER
BROCHE DE CONTRÔLE POUR LA MISE DU CONTACT SUR UNE ZONE ÉLECTRIQUEMENT CONDUCTRICE D'UN PARTENAIRE DE CONTACT

(30) Priorität: 08.04.2011 DE 202011000839 U
(43) Veröffentlichungstag der Anmeldung: 26.12.2012
(73) Patentinhaber: Ingun Prüfmittelbau GmbH, 78467 Konstanz (DE)
(72) Erfinder: BREUL, Peter, 78467 Konstanz (DE)
(74) Vertreter: Wagner, Kilian
(86) Internationale Anmeldenummer: PCT/EP2012/055634
(87) Internationale Veröffentlichungsnummer: WO 2012/136562

(56) Entgegenhaltungen:
- DE-B3-102006 025 850
- DE-U1-202010 007 229
- US-A- 5 633 597

## Beschreibung

Die Erfindung betrifft einen Prüfstift zum Kontaktieren eines elektrisch leitenden Bereichs eines Kontaktpartners nach dem Oberbegriff des Anspruchs 1.

Ein derartiger Prüfstift ist aus der DE 20 2010 007 229 U1 der Anmelderin bekannt. Der in dieser Schrift offenbarte, als Hochfrequenz-Prüfstift ausgebildete Prüfstift dient zum lösbaren Kontaktieren eines einen Innen- sowie einen Außenkontakt aufweisenden Hochfrequenz-Kontaktpartners. Ein derartiger Prüfstift weist ein äußeres Kontaktelement auf, in dem Federzungen angeordnet sind, die beim Aufschieben auf den zu prüfenden Kontaktpartner in Wirkverbindung mit der Außenfläche des Kontaktpartners treten und eine elektrische Verbindung mit diesem herstellen. Weiterhin ist ein inneres Kontaktelement vorgesehen, das im Wesentlichen stiftförmig ausgebildet ist, und das auf der dem Kontaktpartner zugewandten Seite eine ebene Kontaktfläche ausbildet, die in Wirkverbindung mit einem zweiten elektrischen Kontakt des Kontaktpartners treten kann.

Neben dem aus der genannten Schrift bekannten Prüfstift zur Kontaktierung eines Kontaktpartners, der an zwei Stellen elektrisch kontaktiert werden soll, gibt es darüber hinaus Anwendungen, bei denen lediglich eine Kontaktierung an einer einzigen Stelle des Kontaktpartners mittels eines Prüfstifts erforderlich bzw. erwünscht ist. Insbesondere bei Kontaktpartnern, die eine Öffnung aufweisen, in denen der zu kontaktierende Bereich angeordnet ist, ist eine sichere und zuverlässige elektrische Kontaktierung mittels eines Prüfstifts erforderlich.

Aufgabe der Erfindung ist es daher, einen Prüfstift zum Kontaktieren eines elektrisch leitenden Bereichs eines Kontaktpartners nach dem Oberbegriff des Anspruchs 1 derart weiterzubilden, dass dieser zur elektrischen Kontaktierung eines Kontaktpartners geeignet ist, dessen einzige zu kontaktierende Fläche in einer Öffnung angeordnet ist. Diese Aufgabe wird bei einem Prüfstift mit den Merkmalen des Anspruchs 1 erfindungsgemäß im Wesentlichen dadurch gelöst, dass das hülsenförmige Kontaktelement an dem den Kontaktpartner zugewandten Endbereich zum Kontaktieren des Kontaktpartners in Bezug zu seiner Längsachse radial aufweitbar ausgebildet ist, und dass das stiftförmige Element zum radialen Aufweiten des Kontaktelementes mit einer schräg zur Längsachse des Kontaktelementes angeordneten Anlauffläche in Wirkverbindung gegen eine am Kontaktelement ausgebildete Gegenfläche anlegbar ist, so dass eine Linearbewegung des stiftförmigen Elements in einer radialen Aufweitung des Kontaktelements an dessen Endbereich resultiert. Mit anderen Worten gesagt bedeutet dies, dass der Prüfstift einen Kontaktbereich aufweist, der zum elektrischen Kontaktieren des Kontakts sich an einer elektrisch leitenden Innenfläche der Öffnung des Kontaktpartners anlegt, indem der Kontaktbereich des Prüfstifts radial aufgeweitet wird. Dadurch wird eine besonders sichere elektrische Verbindung hergestellt, da der Kontaktbereich die Möglichkeit zulässt, dass sich dieser über den gesamten Umfang der zu kontaktierenden Fläche des Kontaktpartners anliegt. Dadurch wird sichergestellt, dass der Kontaktbereich zumindest an einer Stelle mit der zu kontaktierenden Stelle Kontakt bekommt. Gleichzeitig wird durch die spezielle Ausbildung des stiftförmigen Elementes sowie des Kontaktelements eine besonders einfache und sichere Betätigung bzw. ein zuverlässiges radiales Aufweiten des Kontaktelements ermöglicht.

Weitere vorteilhafte Weiterbildungen des erfindungsgemäßen Prüfstifts zum Kontaktieren eines Kontaktpartners sind in den Unteransprüchen angegeben. In den Rahmen der Erfindung fallen sämtliche Kombinationen aus zumindest zwei von in den Ansprüchen, der Beschreibung und/oder den Figuren offenbarten Merkmalen.

Um eine besonders geschützte Anordnung der beiden Federelemente bei einem im Durchmesser klein bauenden Prüfstift zu ermöglichen, ist es besonders bevorzugt vorgesehen, dass die beiden Federelemente innerhalb des Gehäuses des Prüfstifts und koaxial zueinander angeordnet sind.

In einer besonders bevorzugten konstruktiven Ausgestaltung der Erfindung, die einerseits eine relativ einfache Montage der Teile des Prüfstifts bei gleichzeitig guter Herstellbarkeit der Einzelteile des Prüfstifts ermöglicht wird, wird vorgeschlagen, dass das stiftförmige Element wenigstens zweiteilig ausgebildet ist und ein stabförmiges Führungsteil für die beiden Federelemente aufweist, das auf der den hülsenförmigen Kontaktelementen zugewandten Seite in eine Bohrung, vorzugsweise eine Durchgangsbohrung, eines hülsenförmigen Spreizteils hineinragt und an diesem festgesetzt ist. Dieses Festsetzen kann beispielsweise durch eine entsprechende Presspassung zwischen der Bohrung im Spreizteil und dem stabförmigen Führungsteil erfolgen.

In konstruktiver Weiterbildung des zuletzt genannten Vorschlags wird vorgeschlagen, dass das dem Spreizteil abgewandte Ende des Führungsteils einen Kopfbereich bildet, der im Durchmesser gegenüber dem Führungsteil vergrößert ausgebildet ist, wobei der Kopfbereich innerhalb des Gehäuseelements radial geführt ist, einen Anschlag für die beiden Federelemente ausbildet und von der Federkraft der beiden Federelemente in Richtung einer einen Anschlag bildenden Gegenfläche des Gehäuseelements kraftbeaufschlagt ist. Dadurch wird es ermöglicht, dass das Führungsteil nicht nur der radialen Führung der beiden Federelemente, sondern auch als Anschlag für die beiden Federelemente wirkt, wobei das Ende gleichzeitig einen Bewegungsanschlag für das stiftförmige Element bildet.

Eine Begrenzung der Axialbewegung des Kontaktelementes in Bezug auf das Gehäuseelement lässt sich auf besonders einfache Art und Weise bewirken, wenn das Kontaktelement innerhalb des Gehäuseelements einen im Durchmesser vergrößerten Abschnitt aufweist, der mit einem im Gehäuseelement angeordneten Anschlagbereich zusammenwirkt. Dieser Anschlagbereich bewirkt im unbelasteten Zustand des Kontaktelements, dass dieses von der Federkraft wenigstens eines Federelements aus dem Gehäuseelement herausgedrückt wird.

Ein hinsichtlich der Baulänge besonders kompakter Aufbau des Prüfstifts lässt sich erzielen, wenn die beiden Federelemente in einem Teilbereich ihrer Länge radial ineinander liegend angeordnet sind.

Alternativ ist es jedoch auch möglich, dass die beiden Federelemente axial hintereinander angeordnet sind. Dadurch wird eine (mechanische) Beeinflussung der beiden Federelemente, insbesondere wenn diese einen ähnlichen Durchmesser aufweisen, so dass die Gefahr des gegenseitigen Berührens besteht, vermieden.

Besonders bevorzugt ist es, wenn zur Ausbildung der radialen Aufweitbarkeit des Kontaktelementes der dem Kontaktpartner zugewandte Endbereich des Kontaktelements längsgeschlitzt ausgebildet ist, wobei beim Vorhandensein mehrerer Längsschlitze dies bevorzugt in gleichmäßigen Winkelabständen zueinander angeordnet sind. Insbesondere durch die Anzahl der Längsschlitze lässt sich dabei, bei ansonsten gleichen geometrischen Abmessungen, die für das radiale Aufweiten des Kontaktelements erforderliche Kraft beeinflussen. Weiterhin wird bei einer Vergrößerung der Anzahl der Längsschlitze eine besonders gute Anpassung der Form des radial aufgeweiteten Kontaktelementes an einer kreisförmigen Kontaktfläche des Kontaktpartners ermöglicht.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: einen Längsschnitt durch einen ersten erfindungsgemäßen Prüfstift,
- Fig. 2: den Prüfstift gemäß Fig. 1 während der elektrischen Kontaktierung eines Kontaktpartners in einer teilweise geschnittenen Seitenansicht und
- Fig. 3 und 4: jeweils gegenüber der Fig. 1 abgewandelte Ausführungsformen eines erfindungsgemäßen Prüfstifts, jeweils im Längsschnitt.

Gleiche Bauteile bzw. Bauteile mit gleicher Funktion sind in den Figuren mit den gleichen Bezugsziffern versehen.

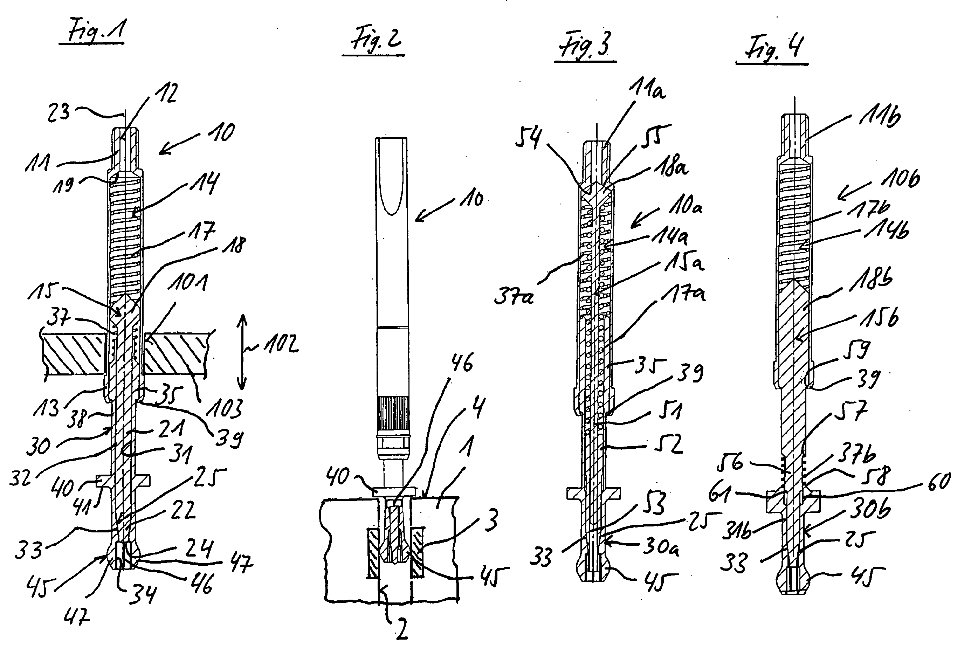

In der Fig. 1 ist ein erstes Ausführungsbeispiel eines erfindungsgemäßen Prüfstifts 10 zum (elektrischen) Kontaktieren eines lediglich in der Fig. 2 erkennbaren Kontaktpartners 1 dargestellt. Hierbei weist der Kontaktpartner 1 eine als Loch ausgebildete Öffnung 2 auf, deren Innenwand ein mittels des Prüfstifts 10 zu kontaktierender, elektrisch leitfähiger Bereich 3 aufweist. Der leitfähige Bereich 3 kann beispielsweise als hülsenförmiger Federkontakt o.ä. ausgebildet sein und ist insbesondere mit einer elektrischen bzw. elektronischen Schaltung gekoppelt, die mittels des Prüfstifts 10 hinsichtlich einer elektrischen Eigenschaft überprüft werden soll.

Der Prüfstift 10 umfasst ein im Wesentlichen hülsenförmiges Gehäuseelement 11, dessen dem Kontaktpartner 1 abgewandeltes Ende eine Bohrung 12 zur Verbindung des Prüfstifts 10 mit einem Messkabel oder ähnlichem aufweist. Der Prüfstift 10 ist mit seinem Gehäuseelement 11 in einer Aufnahmebohrung 101 einer entsprechend des Doppelpfeils 102 auf- und abbeweglichen Aufnahmeeinheit, insbesondere einer Aufnahmeplatte 103, eingesetzt. Insbesondere ist es dabei vorgesehen, dass mehrere erfindungsgemäße Prüfstifte 10 in der Zeichnungsebene der Fig. 1 neben- bzw. hintereinander in der Aufnahmeeinheit 103 angeordnet und befestigt sind, so dass jeweils eine der Zahl der Prüfstifte 10 entsprechende Zahl von Kontaktpartnern 1 gleichzeitig kontaktiert und geprüft werden kann.

Der Außenumfang des Gehäuseelementes 11 ist an dem dem Kontaktpartner 1 zugewandten Endbereich 13 bundartig vergrößert, so dass der Endbereich 13 einen Axialanschlag beim Positionieren des Prüfstifts 10 in der Aufnahmebohrung 101 ausbildet.

Innerhalb eines zylindrischen Innenraums 14 des Gehäuseelementes 11 ist ein Teilbereich eines stiftförmigen Elements 15 auf- und abbeweglich angeordnet. Das stiftförmige Element 15 ist in Wirkverbindung mit einem ersten, insbesondere als Druckfeder ausgebildetem Federelement 17 angeordnet, dass sich zwischen einem im Durchmesser vergrößerten Kopfbereich 18 des stiftförmigen Elements 15 und dem Grund 19 des Innenraums 14 auf der dem Kontaktpartner 1 abgewandten Seite abstützt. Das Federelement 17 bewirkt somit in Folge seiner Federkraft eine Bewegung des stiftförmigen Elements 15 in Richtung auf den Kontaktpartner 1. Ferner ist der Kopfbereich 18 des stiftförmigen Elements 15 in seinem Außendurchmesser derart dimensioniert, dass das stiftförmige Element 15 mittels des Kopfbereichs 18 in dem Innenraum 14 des Gehäuseelements 11 radial geführt ist.

Das stiftförmige Element 15 weist einen sich an den Kopfbereich 18 anschließenden, zylindrischen Mittelbereich 21 auf, an den sich auf der dem Kopfbereich 18 gegenüberliegenden Seite ein konisch geformter Endbereich 22 anschließt.

Der Endbereich 22 schließt mit einer senkrecht zur Längsachse 23 des stiftförmigen Elements 15 bzw. des Prüfstifts 10 angeordneten Stirnfläche 24 ab. Wesentlich ist, dass der Endbereich 22 eine in Bezug zur Längsachse 23 schräg angeordnete Anlauffläche 25 ausbildet.

Das stiftförmige Element 15 ist, mit Ausnahme eines Teilbereichs des Mittelbereichs 21 und des Kopfbereichs 18, in einem ebenfalls im Wesentlichen hülsenförmigen Kontaktelement 30 längsverschiebbar angeordnet. Hierzu weist das Kontaktelement 30 eine Durchgangsbohrung 31 mit mehreren Bohrungsabschnitten 32 bis 34 auf. Der Bohrungsabschnitt 32 dient der Führung des Mittelbereichs 21 des stiftförmigen Elements 15 und weist einen konstanten Durchmesser auf. An den Bohrungsabschnitt 32 schließt sich auf der dem Kontaktpartner 1 zugewandten Seite der Bohrungsabschnitt 33 an, der kegelförmig ausgebildet ist. An den Bohrungsabschnitt 33 schließt sich wiederum ein als Sacklochbohrung ausgebildeter Bohrungsabschnitt 34 an.

Das Kontaktelement 30 weist innerhalb des Innenraums 14 des Gehäuseelements 11 einen im Durchmesser vergrößerten Führungsbereich 35 auf, der der radialen Führung des Kontaktelements 30 innerhalb des Gehäuseelements 11 dient. Hierbei stützt sich ein bevorzugt ebenfalls als Druckfeder ausgebildetes, zweites Federelement 37 zwischen dem Führungsbereich 35 und dem Kopfbereich 18 des stiftförmigen Elements 15 ab, wobei das zweite Federelement 37 zumindest den Mittelbereich 21 des stiftförmigen Elements 15 radial umgibt und von diesem radial geführt ist.

Der Führungsbereich 35 geht auf der dem Kontaktpartner 1 zugewandten Seite in einen einen geringen Durchmesser als der Führungsbereich 35 aufweisenden Mittelabschnitt 38 über. Insbesondere ragt dabei der Mittelabschnitt 38 aus dem Gehäuseelement 11 heraus, wobei das Gehäuseelement 11 auf der dem Kontaktpartner 1 zugewandten Seite einen bundartig nach innen ragenden Anschlagbereich 39 bildet, der mit dem Führungsbereich 35 des Kontaktelements 30 zusammenwirkt, indem er die Axialbewegung des Kontaktelements 30 in Richtung zum Kontaktpartner 1 begrenzt.

Der Mittelabschnitt 38 besitzt weiterhin einen bundartigen Anschlag 40, dessen dem Kontaktpartner 1 zugewandte Unterseite 41 eine Axialbewegung des Kontaktelementes 30 in Bezug auf den Kontaktpartner 1 begrenzt, indem die Unterseite 41 mit der Oberseite 4 des Kontaktpartners 1 zusammenwirkt (Fig. 2).

Der dem Kontaktpartner 1 zugewandte Endbereich 45 des Kontaktelements 30 ist im Längsschnitt im Durchmesser vergrößert und ballenförmig ausgebildet. Erfindungswesentlich ist, dass zumindest der Endbereich 45 in Höhe des Bohrungsabschnitts 34, bevorzugt jedoch auch noch der sich an den Bohrungsabschnitt 34 in Richtung bis in etwa zum Anschlag 40 anschließende Mittelabschnitt 38 des Kontaktelements 30 mit Längsschlitzen 46 ausgestattet ist. Hierbei sind die Längsschlitze 46 bevorzugt zur Längssachse 23 hin ausgerichtet bzw. schneiden diese, und es sind bevorzugt mehrere Längsschlitze 46 vorgesehen, die in gleichmäßigen Winkelabständen zueinander angeordnet sind. Im Ausführungsbeispiel sind sechs, um jeweils 60° zueinander versetzt angeordnete Längsschlitze 46 vorgesehen.

Durch die Längsschlitze 46 wird der Endbereich 45 des Kontaktelementes 30 insofern festigkeitsmäßig geschwächt, als dass die von den Längsschlitzen 46 voneinander getrennten Teilabschnitte 47 des Endbereichs 45 in einer Richtung senkrecht zur Längssachse 23, das heißt in radialer Richtung, elastisch beweglich angeordnet sind. Durch das Vorsehen der sechs Längsschlitze 46 wird dabei der Vorteil erzielt, dass der Prüfstift 10 auch für im Querschnitt viereckige Öffnungen 2 verwendet werden kann.

Die den Außendurchmesser des Endbereichs 45 vergrößerte elastische Bewegung der Teilabschnitte 47 zur Kontaktierung des Bereichs 3 am Kontaktpartner 1 wird durch eine Bewegung des stiftförmigen Elements 15 in Richtung der Längsachse 23 erzeugt, wenn dieses sich in Bezug auf das Kontaktelement 30 in Richtung auf den Kontaktpartner 1 bewegt. Diese Relativbewegung wird bei der Abwärtsbewegung des Prüfstifts 10 hergerufen, wenn der Anschlag 40 mit der Oberseite 4 des Kontaktpartners 1 in Kontakt kommt. Bis zu diesem Zeitpunkt bleiben die Teilabschnitte 47 in ihrer radial inneren Stellung. Sobald die Anlauffläche 25 in Wirkverbindung mit der als Gegenfläche für die Anlauffläche 25 wirkenden Bohrungsabschnitt 33 des Kontaktelements 30 gerät, wird eine Querkraft erzeugt, die die Teilabschnitte 47 des Endbereichs 45 radial nach außen bewegt. In umgekehrter Weise bewegen sich die Teilabschnitte 47 des Endbereichs 45 in ihre ursprüngliche radiale innere Position zurück, wenn das stiftförmige Element 15 in Bezug auf das Kontaktelement 30 vom Kontaktpartner 1 wegbewegt wird. Dabei bewirkt die Federkraft des Federelements 37 eine Axialbewegung des Kontaktelements 30 zum stiftförmigen Element 15 derart, dass die Teilabschnitte 47 des Endbereichs 45 wieder ihre Ursprungsposition einnehmen können. Wichtig dabei ist, dass diese radial innere Position der Teilabschnitte 47 erreicht wird, bevor der Prüfstift 10 wieder aus der Öffnung 2 herausfährt. Dies wird durch eine entsprechende Auslegung der beiden Federelemente 17, 37 erzielt.

In der Fig. 3 ist ein gegenüber der Fig. 1 abgewandelter Prüfstift 10a dargestellt. Die Änderung gegenüber dem Prüfstift 10 besteht im Wesentlichen darin, dass das stiftförmige Element 15a aus zwei Teilen besteht, einem stabförmigen Führungsteil 51 und einem hülsenförmigen Spreizteil 52, das eine Durchgangsbohrung 53 aufweist, in der der dem Kontaktpartner 1 zugewandte Endbereich des Spreizteils 52, z.B. durch eine Presspassung, aufgenommen ist. Ferner weist das Führungsteil 51 auf der dem Spreizteil 52 abgewandten Seite eignen Kopfbereich 18a auf, dessen dem Spreizteil 52 abgewandte Stirnfläche 54 kegelförmig ausgebildet ist, wobei die Stirnfläche 54 mit einer entsprechenden Gegenfläche 55 des Gehäuseelements 11a einen Anschlag für das stiftförmige Element 15a ausbildet. Wesentlich ist noch, dass die beiden Federelemente 17a, 37a in einem Teilbereich ihrer Länge innerhalb des Innenraums 14a radial ineinander liegend angeordnet sind, während bei dem Prüfstift 10 gemäß der Fig. 1 die beiden Federelemente 17, 37 zwar koaxial zueinander angeordnet, jedoch axial zueinander beabstandet sind.

In der Fig. 4 ist ein gegenüber den Fig. 1 und 3 nochmals abgewandelter Prüfstift 10b dargestellt. Bei dem Prüfstift 10b ist lediglich das stiftförmige Element 15b im Gehäuseelement 11 b geführt, nicht jedoch das Kontaktelement 30b. Das stiftförmige Element 15b weist innerhalb des Innenraums 14b des Gehäuseelements 11 b einen in seiner axialen Länge gegenüber den Kopfbereichen 18, 18a verlängerten Kopfbereich 18b auf, an dessen dem Kontaktelement 30b abgewandter Stirnseite das erste Federelement 17b anliegt. Das zweite Federelement 37b ist außerhalb des Gehäuseelements 11 b angeordnet und umfasst einen im Durchmesser verringerten Teilabschnitt 56 des stiftförmigen Elements 15b radial. Hierbei stützt es sich zwischen einer Stufe 57 am stiftförmigen Element 15b und einer Stirnseite 58 des Kontaktelement 30b ab, das in seiner axialen Länge gegenüber den Kontaktelementen 30, 30a der beiden Prüfstifte 10, 10a deutlich verkürzt ausgebildet ist. Weiterhin liegt der Kopfbereich 18b mit seinem dem Anschlagbereich 39 zugewandten Ende, das als Stufe 59 ausgebildet ist, an dem Anschlagbereich 39 an, falls die vom Federelement 17b erzeugte Kraft größer ist als die vom Federelement 37b erzeugte Kraft.

Die Durchgangsbohrung 31 b des Kontaktelements 30b ist in einem Bohrungsabschnitt 60 im Durchmesser vergrößert ausgebildet, wobei der Grund des Bohrungsabschnitts 60 einen Bewegungsanschlag für eine Stufe 61 des stiftförmigen Elements 15b bildet.
Die soweit beschriebenen Prüfstifte 10, 10a, 10b können in vielfältiger Art und Weise abgewandelt bzw. modifiziert werden, ohne vom Erfindungsgedanken abzuweichen. Dieser besteht in einer sicheren elektrischen Kontaktierung des Kontaktpartners 1 durch eine radiale Aufweitung des Endbereichs 45 des Kontaktelements 30, 30b durch ein stiftförmiges Element 15, 15a, 15b.

### Bezugszeichenliste

| | |
|---|---|
| 1 | Kontaktpartner |
| 2 | Öffnung |
| 3 | Bereich |
| 4 | Oberseite |
| 10,10a,10b | Prüfstift |
| 11,11a,11b | Gehäuseelement |
| 12 | Bohrung |
| 13 | Endbereich |
| 14,14a,14b | Innenraum |
| 15,15a,15b | Element |
| 17,17a,17b | Federelement |
| 18,18a,18b | Kopfbereich |
| 19 | Grund |
| 21 | Mittelbereich |
| 22 | Endbereich |
| 23 | Längsachse |
| 24 | Stirnfläche |
| 25 | Führungsbereich |
| 30,30b | Kontaktelement |
| 31 | Durchgangsbohrung |
| 32 | Bohrungsabschnitt |
| 33 | Bohrungsabschnitt |
| 34 | Bohrungsabschnitt |
| 35 | Führungsbereich |
| 37,37a,37b | zweites Federelement |
| 38 | Mittelabschnitt |
| 39 | Anschlagbereich |
| 40 | Anschlag |
| 41 | Unterseite |
| 45 | Endbereich |
| 46 | Längsschlitz |
| 47 | Teilabschnitte |
| 51 | Führungsteil |
| 52 | Spreizteil |
| 53 | Durchgangsbohrung |
| 54 | Stirnfläche |
| 55 | Gegenfläche |
| 56 | Teilabschnitt |
| 57 | Stufe |
| 58 | Stirnseite |
| 59 | Stufe |
| 60 | Bohrungsabschnitt |
| | |
| | |
| 101 | Aufnahmebohrung |
| 102 | Doppelpfeil |
| 103 | Aufnahmeeinheit |

## Patentansprüche

1. Prüfstift (10; 10a; 10b) zum Kontaktieren eines elektrisch leitenden Bereichs (3) eines Kontaktpartners (1), mit einem insbesondere hülsenförmigen Gehäuseelement (11; 11a; 11 b), einem als Leiter wirkenden, insbesondere ebenfalls hülsenförmiges Kontaktelement (30; 30a; 30b), das in Längsrichtung des Gehäuseelements (11; 11a; 11b) relativ zum Gehäuseelement (11; 11a; 11b) beweglich angeordnet ist, wobei das Kontaktelement (30; 30a; 30b) von einem Federelement (37; 37a; 37b) in Axialrichtung kraftbeaufschlagt ist, und mit einem zumindest bereichsweise innerhalb des Kontaktelements (30; 30a; 30b) geführten, insbesondere stiftförmigem Element (15; 15a; 15b), das von einem weiteren Federelement (17; 17a; 17b) in Axialrichtung kraftbeaufschlagt ist,
**dadurch gekennzeichnet,**
**dass** das hülsenförmige Kontaktelement (30; 30a; 30b) an dem dem Kontaktpartner (1) zugewandten Endbereich (45) zum Kontaktieren des Bereichs (3) des Kontaktpartners (1) in Bezug zu seiner Längsachse (23) radial aufweitbar ausgebildet ist, und dass das stiftförmige Element (15; 15a; 15b) zum radialen Aufweiten des Kontaktelements (30; 30a; 30b) mit einer schräg zur Längsachse (23) des Kontaktelements (30; 30a; 30b) angeordneten Fläche (25) in Wirkverbindung gegen eine am Kontaktelement (30; 30a; 30b) ausgebildete Gegenfläche (33) anlegbar ist, so dass eine Linearbewegung des stiftförmigen Elements (15; 15a; 15b) eine radiale Aufweitung des Kontaktelements (30; 30a; 30b) an dessen Endbereich (45) erzeugt.

2. Prüfstift nach Anspruch 1,
**dadurch gekennzeichnet,**
**dass** das Gehäuseelement (11; 11a; 11 b) an seinem Außenumfang einen im Durchmesser vergrößerten, bundartigen Bereich (13) zur Begrenzung der Bewegung des Prüfstifts (10; 10a; 10b) in einer Aufnahme (101) eines Aufnahmeelements (103), insbesondere einer Aufnahmeplatte aufweist.

3. Prüfstift nach Anspruch 1 oder 2,
**dadurch gekennzeichnet,**
**dass** das Kontaktelement (30; 30a; 30b) an dem dem Kontaktpartner (1) zugewandten Endbereich (45) längsgeschlitzt ausgebildet ist, wobei beim Vorhandensein mehrerer Längsschlitze (46) diese bevorzugt in gleichmäßigen Winkelabständen zueinander angeordnet sind.

4. Prüfstift nach einem der Ansprüche 1 bis 3,
**dadurch gekennzeichnet,**
**dass** das Kontaktelement (30; 30a; 30b) an seiner Außenfläche einen insbesondere bundartigen Anschlag (40) aufweist, der zur Begrenzung der Axialbewegung des Kontaktelements (30; 30a; 30b) mit einer Stirnseite (4) des Kontaktpartners (1) zusammenwirkt.

5. Prüfstift nach einem der Ansprüche 1 bis 4,
**dadurch gekennzeichnet,**
**dass** beide Federelemente (17; 17a, 37; 37a) innerhalb des Gehäuseelements (11; 11a) und koaxial zueinander angeordnet sind.

6. Prüfstift nach Anspruch 1 bis 5,
**dadurch gekennzeichnet,**
**dass** das stiftförmige Element (15a) wenigstens zweiteilig ausgebildet ist und ein stabförmiges Führungsteil (51) zur Führung der beiden Federelemente (17a; 37a) aufweist, das auf der dem hülsenförmige Kontaktelement (30a) zugewandten Seite in eine Bohrung (53), vorzugsweise eine Durchgangsbohrung, eines hülsenförmigen Spreizteils (52) hineinragt und an diesem festgesetzt ist.

7. Prüfstift nach Anspruch 6,
**dadurch gekennzeichnet,**
**dass** das dem Spreizteil (52) abgewandte Ende des Führungsteils (51) einen Kopfbereich (18a) bildet, der im Durchmesser gegenüber dem Führungsteil (51) vergrößert ausgebildet ist, wobei der Kopfbereich (18a) innerhalb des Gehäuseelements (11a) radial geführt ist, einen Anschlag für die beiden Federelemente (17a; 37a) ausbildet und von der Federkraft der beiden Federelemente (17a; 37a) in Richtung einer einen Anschlag bildenden Gegenfläche (55) des Gehäuseelements (11a) kraftbeaufschlagt ist.

8. Prüfstift nach einem der Ansprüche 1 bis 7,
**dadurch gekennzeichnet,**
**dass** das Kontaktelement (30; 30a) innerhalb des Gehäuseelements (11; 11a) einen im Durchmesser vergrößerten Abschnitt (35) aufweist, der zur Begrenzung der Axialbewegung des Kontaktelements (30; 30a) mit einem am Gehäuseelement (11; 11a) angeordneten Anschlagbereich (39) zusammenwirkt.

9. Prüfstift nach einem der Ansprüche 1 bis 8,
**dadurch gekennzeichnet,**
**dass** die beiden Federelemente (17a; 37a) in einem Teilbereich ihrer Länge radial ineinander liegend angeordnet sind.

10. Prüfstift nach einem der Ansprüche 1 bis 9,
**dadurch gekennzeichnet,**
**dass** die beiden Federelemente (17; 17a, 37; 37a) axial hintereinander angeordnet sind.

11. Prüfstift nach Anspruch 10,
**dadurch gekennzeichnet,**
**dass** die beiden Federelemente (17, 37) durch einen Kopfbereich (18) des stiftförmigen Elements (15) voneinander getrennt angeordnet sind.

12. Prüfstift nach Anspruch 10,
**dadurch gekennzeichnet,**
**dass** das eine Federelement (37b) außerhalb des Gehäuseelements (11b) angeordnet ist und das stiftförmige Element (15b) in einem im Durchmesser verringerten Teilabschnitt (56) radial umfasst, wobei sich das eine Federelement (37b) an einer Stirnseite (58) des Kontaktelements (30b) abstützt.

13. Prüfstift nach Anspruch 10 oder 12,
**dadurch gekennzeichnet,**
**dass** das Kontaktelement (15b) einen im Durchmesser vergrößerten Bohrungsabschnitt (60) aufweist, dessen Grund einen Bewegungsanschlag für eine Stufe (61) des stiftförmigen Elements (15b) ausbildet.

## Claims

1. Testing pin (10; 10a; 10b) for contacting an electrically conductive region (3) of a contact partner (1), comprising an in particular sleeve-shaped housing element (11; 11 a; 11 b), an in particular likewise sleeve-shaped contact element (30; 30a; 30b) which acts as a conductor and is arranged such that it can move relative to the housing element (11; 11a; 11 b) in the longitudinal direction of the housing element (11; 11a; 11b), the contact element (30; 30a; 30b) being subjected to force in the axial direction by a spring element (37; 37a; 37b), and comprising an in particular pin-shaped element (15; 15a; 15b) which is guided inside the contact element (30; 30a; 30b) at least in regions and is subjected to force in the axial direction by a further spring element (17; 17a; 17b), **characterised in that** the sleeve-shaped contact element (30; 30a; 30b) on the end region (45) facing the contact partner (1) is configured to be radially expandable relative to the longitudinal axis (23) thereof to contact the region (3) of the contact partner (1), and **in that** the pin-shaped element (15; 15a; 15b) can be applied in an operative connection to a surface (25) which is arranged so as to be oblique to the longitudinal axis (23) of the contact element (30; 30a; 30b) against a counterface (33) formed on the contact element (30; 30a; 30b), such that a linear movement of the pin-shaped element (15; 15a; 15b) causes a radial expansion of the contact element (30; 30a; 30b) on the end region (45) thereof.

2. Testing pin according to claim 1, **characterised in that** the housing element (11; 11 a; 11 b) comprises a collar-like region (13), having an enlarged diameter, on the outer periphery thereof to limit the movement of the testing pin (10; 10a; 10b) in a recess (101) of a retaining element (103), in particular of a retaining plate.

3. Testing pin according to either claim 1 or claim 2, **characterised in that** the contact element (30; 30a; 30b) is formed as a longitudinal slot in the end region (45) facing the contact partner (1), in the presence of a plurality of longitudinal slots (46), said slots being arranged at regular angular distances from each other.

4. Testing pin according to any of claims 1 to 3, **characterised in that** the contact element (30; 30a; 30b) comprises an in particular collar-like stop (40) on the outer surface thereof which cooperates with an end face (4) of the contact partner (1) to limit the axial movement of the contact element (30; 30a; 30b).

5. Testing pin according to any of claims 1 to 4, **characterised in that** the two spring elements (17; 17a, 37; 37a) are arranged inside the housing element (11; 11a) and coaxial with each other.

6. Testing pin according to claims 1 to 5, **characterised in that** the pin-shaped element (15a) is formed in at least two parts and comprises a rod-shaped guide part (51) for guiding the two spring elements (17a; 37a), which guide part projects into a hole (53), preferably a through-hole, of a sleeve-shaped expansion part (52) on the side facing the sleeve-shaped contact element (30a) and is fixed thereto.

7. Testing pin according to claim 6, **characterised in that** the end of the guide part (51) facing away from the expansion part (52) forms a head region (18a) which has an enlarged diameter relative to the guide part (51), the head region (18a) being guided radially inside the housing element (11a), forming a stop for the two spring elements (17a; 37a) and being subjected to the spring force of the two spring elements (17a; 37a) in the direction of an counterface (55) forming a stop of the housing element (11a).

8. Testing pin according to any of claims 1 to 7, **characterised in that** the contact element (30; 30a) inside the housing element (11; 11a) comprises a portion (35) having an enlarged diameter, which portion cooperates with a stop region (39) arranged on the housing element (11; 11a) to limit the axial movement of the contact element (30; 30a).

9. Testing pin according to any of claims 1 to 8, **characterised in that** the two spring elements (17a; 37a) are arranged so as to lie radially one inside the other in a partial region of the length thereof.

10. Testing pin according to any of claims 1 to 9, **characterised in that** the two spring elements (17; 17a, 37; 37a) are arranged axially one behind the other.

11. Testing pin according to claim 10, **characterised in that** the two spring elements (17; 37) are arranged such that they are separated from each other by a head region (18) of the pin-shaped element (15).

12. Testing pin according to claim 10, **characterised in that** one spring element (37b) is arranged outside the housing element (11b) and radially surrounds the pin-shaped element (15b) in a segment (56) having a reduced diameter, said one spring element (37b) being supported on an end face (58) of the contact element (30b).

13. Testing pin according to either claim 10 or claim 12, **characterised in that** the contact element (15b) comprises a hole portion (60) having an enlarged diameter, the base of which forms a movement stop for a step (61) of the pin-shaped element (15b).

## Revendications

1. Broche de contrôle (10 ; 10a ; 10b) pour la mise en contact d'une zone électriquement conductrice (3) d'un partenaire de contact (1), comprenant un élément de boîtier (11 ; 11a ; 11b) en particulier en forme de douille, un élément de contact (30 ; 30a ; 30b), en particulier également en forme de douille, agissant en tant que conducteur, lequel élément de contact est disposé de manière mobile par rapport à l'élément de boîtier (11 ; 11a ; 11b) dans la direction longitudinale de l'élément de boîtier (11 ; 11a; 11b), l'élément de contact (30 ; 30a ; 30b) étant sollicité par une force dans la direction axiale, par un élément de ressort (37 ; 37a ; 37b), et comprenant un élément (15 ; 15a ; 15b) en particulier en forme de broche guidé au moins dans certaines zones à l'intérieur de l'élément de contact (30 ; 30a ; 30b), lequel élément est sollicité par une force dans la direction axiale, par un autre élément de ressort (17 ; 17a ; 17b),
**caractérisée en ce que**
l'élément de contact en forme de douille (30 ; 30a ; 30b), au niveau de la zone d'extrémité (45) tournée vers le partenaire de contact (1), est réalisé de manière à pouvoir être élargi radialement par rapport à son axe longitudinal (23) en vue de la mise en contact de la zone (3) du partenaire de contact (1), et **en ce que** l'élément en forme de broche (15 ; 15a ; 15b) peut être appliqué en liaison fonctionnelle, par une surface (25) disposée de manière inclinée par rapport à l'axe longitudinal (23) de l'élément de contact (30 ; 30a ; 30b), contre une surface conjuguée (33) réalisée sur l'élément de contact (30 ; 30a ; 30b), en vue de l'élargissement radial de l'élément de contact (30 ; 30a ; 30b), de telle sorte qu'un déplacement linéaire de l'élément en forme de broche (15 ; 15a ; 15b) produise un élargissement radial de l'élément de contact (30 ; 30a ; 30b) au niveau de sa zone d'extrémité (45).

2. Broche de contrôle selon la revendication 1,
**caractérisée en ce que**
l'élément de boîtier (11 ; 11a ; 11b) comprend sur sa périphérie extérieure une zone (13) de type épaulement, de diamètre agrandi, en vue de la limitation du déplacement de la broche de contrôle (10 : 10a ; 10b) dans un logement (101) d'un élément de réception (103), en particulier d'une plaque de réception.

3. Broche de contrôle selon la revendication 1 ou 2,
**caractérisée en ce que**
l'élément de contact (30 ; 30a ; 30b) est réalisé de manière fendue longitudinalement au niveau de la zone d'extrémité (45) tournée vers le partenaire de contact (1) et, en présence de plusieurs fentes longitudinales (46), celles-ci étant de préférence disposées à des écarts angulaires réguliers les unes par rapport aux autres.

4. Broche de contrôle selon l'une quelconque des revendications 1 à 3,
**caractérisée en ce que**
l'élément de contact (30 ; 30a ; 30b) comprend sur sa surface extérieure une butée (40) en particulier de type épaulement, laquelle butée coopère avec une face frontale (4) du partenaire de contact (1) en vue de la limitation du déplacement axial de l'élément de contact (30 ; 30a ; 30b).

5. Broche de contrôle selon l'une quelconque des revendications 1 à 4,
**caractérisée en ce que**
les deux éléments de ressort (17 ; 17a, 37 ; 37a) sont disposés de manière coaxiale l'un par rapport à l'autre à l'intérieur de l'élément de boîtier (11 ; 11a).

6. Broche de contrôle selon l'une quelconque des revendications 1 à 5,
**caractérisée en ce que**
l'élément en forme de broche (15a) est réalisé au moins en deux parties et comprend une partie de guidage (51) en forme de barre en vue du guidage des deux éléments de ressort (17a ; 37a), laquelle partie de guidage, du côté tourné vers l'élément de contact (30a) en forme de douille, pénètre dans un alésage (53), de préférence un alésage traversant, d'une partie d'écartement (52) en forme de douille et est fixé à cette partie d'écartement.

7. Broche de contrôle selon la revendication 6,
**caractérisée en ce que**
l'extrémité, opposée à la partie d'écartement (52), de la partie de guidage (51) forme une zone de tête (18a) qui est réalisée avec un diamètre agrandi par rapport à la partie de guidage (51), la zone de tête (18a) étant guidée radialement à l'intérieur de l'élément de boîtier (11a), formant une butée pour les deux éléments de ressort (17a ; 37a) et étant sollicitée par la force de ressort des deux éléments de ressort (17a ; 37a) en direction d'une surface conjuguée (55) de l'élément de boîtier (11a) formant une butée.

8. Broche de contrôle selon l'une quelconque des revendications 1 à 7,
**caractérisée en ce que**
l'élément de contact (30 ; 30a) comprend, à l'intérieur de l'élément de boîtier (11 ; 11a), une section (35) de diamètre agrandi qui coopère avec une zone de butée (39) disposée sur l'élément de boîtier (11 ; 11a) en vue de la limitation du déplacement axial de l'élément de contact (30 ; 30a).

9. Broche de contrôle selon l'une quelconque des revendications 1 à 8,
**caractérisée en ce que**
les deux éléments de ressort (17a ; 37a) sont disposés de manière à être situés radialement l'un dans l'autre dans une zone partielle de leur longueur.

10. Broche de contrôle selon l'une quelconque des revendications 1 à 9,
**caractérisée en ce que**
les deux éléments de ressort (17a ; 17a, 37 ; 37a) sont disposés l'un derrière l'autre axialement.

11. Broche de contrôle selon la revendication 10,
**caractérisée en ce que**
les deux éléments de ressort (17, 37) sont disposés de manière à être séparés l'un de l'autre par une zone de tête (18) de l'élément en forme de broche (15).

12. Broche de contrôle selon la revendication 10,
**caractérisée en ce que**
l'un des éléments de ressort (37b) est disposé à l'extérieur de l'élément de boîtier (11b) et entoure radialement l'élément en forme de broche (15b) dans une section partielle (56) de diamètre réduit, l'un des éléments de ressort (37b) s'appuyant contre une face frontale (58) de l'élément de contact (30b).

13. Broche de contrôle selon la revendication 10 ou 12,
**caractérisée en ce que**
l'élément de contact (15b) comprend une section d'alésage (60) de diamètre agrandi, dont le fond forme une butée de déplacement pour un gradin (61) de l'élément en forme de broche (15b).
